(19) Europäisches Patentamt
European Patent Office
Office européen des brevets

(11) Numéro de publication: **0 300 893 B1**

(12) # FASCICULE DE BREVET EUROPEEN

(45) Date de publication de fascicule du brevet: **03.02.93** (51) Int. Cl.[5]: **H03H 7/32**

(21) Numéro de dépôt: **88401864.9**

(22) Date de dépôt: **19.07.88**

(54) **Dispositif de retard hyperfréquence.**

(30) Priorité: **20.07.87 FR 8710240**

(43) Date de publication de la demande:
**25.01.89 Bulletin 89/04**

(45) Mention de la délivrance du brevet:
**03.02.93 Bulletin 93/05**

(84) Etats contractants désignés:
**BE DE ES GB GR IT LU NL SE**

(56) Documents cités:
**GB-A- 2 044 568**
**US-A- 2 702 372**

**PATENT ABSTRACTS OF JAPAN, vol. 1, no. 94, 27 août 1977, page 2616 E 77; & JP-A-52 28 839 (TOKYO DENKI KAGAKU KOGYO K.K.) 04-03-1977**

**THE RADIO AND ELECTRONIC ENGINEER, vol. 43, no. 12, décembre 1973, pages 729-743, Londres, GB; L.E. WEAVER: "The design of a precision video delay line"**

(73) Titulaire: **ELECTRONIOUE SERGE DASSAULT**
**55, quai Marcel Dassault**
**F-92214 Saint-Cloud(FR)**

(72) Inventeur: **Ouvrard, Pierre-Louis**
**25, avenue de l'Europe**
**F-92070 Sevres(FR)**
Inventeur: **Dueme, Philippe**
**5, route de Nozay Villejust**
**F-91120 Palaiseau(FR)**

(74) Mandataire: **Plaçais, Jean-Yves et al**
**Cabinet Netter, 40, rue Vignon**
**F-75009 Paris(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).



Rank Xerox (UK) Business Services

## Description

La présente invention concerne la réalisation de lignes de transmission en hyperfréquence. Plus particulièrement, elle a pour objet un dispositif de retard hyperfréquence agencé en filtre passe-tout, en technologie monolithique sur arséniure de gallium. Elle trouve une application dans la réalisation de lignes de transmission à longueur programmable.

L'homme de l'art connait l'intérêt, en hyperfréquence de la technologie monolithique sur arséniure de gallium (As Ga).

Toutefois, un problème se pose pour les lignes à retard : pour obtenir l'équivalent d'une ligne de transmission dans l'air d'une longueur de l'ordre de 1 centimètre, sous une impédance de 50 ohms, il faudrait une surface d'AsGa de l'ordre de 1 millimètre carré.

Une telle ligne à retard n'est pas satisfaisante car le rapport entre la surface d'AsGa utilisée et la longueur de la ligne équivalente dans l'air est très élevé. Ce problème technologique rend onéreuse et difficile la réalisation d'une telle fonction sur un substrat d'AsGa.

L'invention a pour but d'apporter une solution à ce problème. A cette fin, elle propose un dispositif de retard hyperfréquence agencé en filtre passe-tout avec une loi de phase linéaire en fonction de la fréquence susceptible, notamment en technologie AsGa, d'occuper une surface plus réduite grâce à une disposition particulière des éléments constitutifs et essentiels du dispositif de l'invention.

L'invention porte sur un dispositif de retard hyperfréquence comportant au moins un quadripôle du type dit "cellule dérivée en m" agencé en filtre passe-tout, avec une loi de phase linéaire en fonction de la fréquence, (GB-A-2 044 568 ou The radio and electronic engineer, vol. 43, n° 12, décembre 1973, pages 729-743) le quadripôle étant constitué d'une cellule en T ponté comprenant :

- deux inductances de même valeur (L) montées en série pour former les deux branches du T, et possédant une inductance mutuelle (M) ;
- une capacité ($C_2$) définissant l'âme du T ; et
- une autre capacité ($C_1$) formant le pont. (The radio and electronic engineer, vol. 43, n° 12, décembre 1973, pages 729743).

Selon une définition générale de l'invention, le dessin de la structure du dispositif en technologie planaire comprend au moins une cellule élémentaire constituée, entre une entrée et une sortie situées à distance l'une de l'autre, d'une spirale, mise en parallèle sur une capacité de structure métal-isolant-métal, tandis que le point médian de la spirale est relié par l'intermédiaire d'une autre capacité de structure métal-isolant-métal à un plan de masse.

On appelle ici "passe-tout", en hyperfréquence, un circuit dont la bande passante couvre au moins une dizaine de giga-Hertz, et "cellule dérivée en m" une cellule en T ponte, telle que définie ci-dessus, et tous ses équivalents électriques.

Le dispositif de l'invention trouve une application dans la réalisation de lignes de transmission à longueur programmable. Selon une autre caractéristique de l'invention, le quadripôle est monté commutable en parallèle sur une voie directe formant sensiblement un court-circuit commutable.

Selon un mode préféré de réalisation de l'invention, le dispositif obéit sensiblement à la relation :

$$C_2 \cdot \left(\frac{L - M}{L + M}\right) = 4 \cdot C_1$$

En pratique, pour suivre la loi de phase linéaire en fonction de la fréquence, le quotient de l'inductance mutuelle (M) par la somme de l'inductance (L) et de l'inductance mutuelle (M) est compris entre +0,2 et +0,4, de préférence entre +0,28 et 0,34 environ.

Avantageusement, ledit rapport est compris entre +0,30 et +0,33.

De préférence, la spirale s'étend sur environ un tour trois quarts.

En pratique, le dispositif de l'invention est réalisé en technologie monolithique sur arséniure de gallium.

Cette disposition particulière des éléments constitutifs et essentiels du dispositif de l'invention a l'avantage de réduire environ d'un facteur 10 par rapport aux lignes de transmission classiques (50 ohms) réalisées sur un substrat d'AsGa, le rapport entre la surface d'AsGa nécessaire à la réalisation d'une telle ligne et la longueur équivalente de la ligne dans l'air.

Selon une autre caractéristique du dispositif de l'invention, il comprend plusieurs cellules distribuées autour d'un même plan de masse, et montées en série.

Cette dernière caractéristique permet de réaliser des lignes de transmission de plus importante longueur.

D'autres caractéristiques et avantages de l'invention apparaîtront à l'examen de la description détaillée ci-après, et des dessins annexés, sur lesquels :

- la figure 1 représente schématiquement une cellule élémentaire dérivée en m, chargée en amont et en aval sur ses impédances image utilisable selon l'invention;
- la figure 2 représente schématiquement la

cellule élémentaire représentée en figure 1 dans laquelle une capacité série est ajoutée utilisable préférentiellement selon l'invention;

- les figures 3 et 4 sont deux schémas équivalents différents de la cellule de la figure 2;
- la figure 5 illustre schématiquement la variation, pour plusieurs valeurs d'une variable proportionnelle au quotient de l'inductance mutuelle (M) par la somme de l'inductance (L) et l'inductance mutuelle (M), d'une variable proportionnelle au retard du dispositif en fonction d'une autre variable proportionnelle à la fréquence;
- la figure 6 illustre schématiquement la variation, pour plusieurs valeurs de deux fois la somme de l'inductance (L) et de l'inductance mutuelle (M), du retard du dispositif en fonction de la fréquence;
- la figure 7 représente un dessin de la structure du dispositif de l'invention;
- la figure 8 représente une vue en coupe illustrant la structure de la cellule au niveau d'une inductance;
- la figure 9 représente une vue en coupe illustrant la structure métal-isolant-métal d'une capacité;
- la figure 10 représente une vue en coupe illustrant la structure de la cellule au niveau du plan de masse;
- la figure 11 représente la variation des pertes (transmission, réflexion) en fonction de la fréquence du dispositif selon l'invention;
- la figure 12 représente schématiquement la variation du déphasage du dispositif en fonction de la fréquence selon l'invention;
- la figure 13 représente une disposition particulière de neuf cellules distribuées autour d'un même plan de masse selon l'invention; et
- la figure 14 représente schématiquement la commutation d'une ligne de longueur programmable selon l'invention.

Les dessins annexés comportent à de nombreux titres des éléments de caractère certain. Ils pourront donc non seulement servir à éclairer la description ci-après, mais aussi contribuer à la définition de l'invention, le cas échéant.

La description qui va suivre est donnée à titre purement illustratif mais non limitatif.

Sur la figure 1, la référence 2 désigne un quadripôle du type "cellule dérivée en m". La cellule 2 a la forme d'un T et comprend une capacité définissant l'âme du T et deux éléments inductifs L de même valeur montés en série pour former les deux branches du T. Les deux éléments inductifs L créent entre eux une mutuelle induction M.

Dans le cas d'une mise en cascade de plusieurs cellules 2 pour réaliser des lignes de transmission sous une impédance de 50 ohms, la cellule 2 est chargée respectivement en amont et en aval sur ses impédances image respectivement $W_e$ et $W_s$.

Une impédance image est une impédance que l'on charge par exemple en sortie du quadripôle pour obtenir à ladite entrée la même impédance.

Le chargement en amont (entrée) et en aval (sortie) sur les impédances images de la cellule 2 permet d'obtenir ainsi une adaptation d'impédance entrée-sortie.

Sur la figure 2, le quadripôle 4 comprend les éléments de la cellule 2 décrite en référence à la figure 1 et dans laquelle on a ajouté une capacité série $C_1$.

La capacité série $C_1$ est pontée entre les deux éléments inductifs L.

Sur la figure 3, la référence 6 désigne un quadripôle équivalent et différent du quadripôle de la figure 2.

La cellule 6 comprend deux éléments inductifs constituant à eux deux une inductance équivalente série $L_1$, une capacité équivalente série $C_1$ pontée entre les deux éléments inductifs de l'inductance équivalente série $L_1$, une capacité équivalente parallèle $C_2$, et une inductance équivalente parallèle $L_2$. Les deux éléments inductifs de l'inductance équivalente série $L_1$ créent entre eux une mutuelle induction M, laquelle définit aussi l'inductance équivalente parallèle $L_2$. La mutuelle induction M des deux éléments inductifs de l'inductance équivalente série est donc égale en valeur absolue à l'inductance équivalente parallèle $L_2$.

Sur la figure 4, la référence 8 désigne un quadripôle comprenant les mêmes éléments que le quadripôle 6 décrit en référence à la figure 3, mais dont la disposition est différente.

Le quadripôle 8 comprend :

- deux branches série directes $Z_a$ comprenant chacune le montage en parallèle d'une inductance égale à la moitié de l'inductance équivalente série $L_1$ et d'une capacité égale au double de la capacité équivalente série $C_1$ ; et
- deux branches série croisées $Z_b$, comprenant chacune, en série, une inductance égale à la somme de la moitié de l'inductance équivalente série $L_1$ et du double de l'inductance équivalente parallèle $L_2$, ainsi qu'une capacité égale à la moitié de la capacité équivalente parallèle $L_2$.

Une telle cellule 8 permet d'obtenir un filtre passe-tout avec une loi de phase linéaire en fonction de ladite fréquence lorsqu'elle obéit à la relation :

$$C_2 \cdot (1 + 4 \frac{L_2}{L_1}) = 4 \cdot C_1$$

et lorsqu'elle est chargée sur ses impédances image, c'est-à-dire $\sqrt{Z_a \times Z_b} = 50$ ohms.

Toutefois, la cellule 8 est irréalisable en pratique avec des éléments linéaires passifs. La caractéristique essentielle de l'invention est de transposer la relation de la cellule 8 à la cellule 4 équivalente dont les éléments sont réalisables en pratique et d'associer à ladite cellule 4 une loi de phase en fonction de la fréquence présentant une propriété linéaire afin d'utiliser cette propriété linéaire pour réaliser des lignes de transmission de signaux analogiques en hyperfréquence de l'ordre par exemple de 2 à 20 gigahertz.

Pour la cellule 4, la relation à vérifier est maintenant la suivante :

$$C_2 \cdot (\frac{L - M}{L + M}) = 4 \cdot C_1$$

avec $L_1 = 2 (L + M)$
et $L2 = -M$.

Le déphasage D du signal entre l'entrée et la sortie dans une cellule 4 décrite en référence à la figure 2 a pour expression :

$$D = 2 \text{ Arctang } (\frac{xk}{1-xk^2(1+u)})$$

où

$$u = - \frac{2M}{L + M}$$

et $xk = \pi f 2\sqrt{(L + M) \cdot C_2}$

f étant la fréquence des signaux transmis.

L'étude de la variation du déphasage en fonction de la fréquence permet de déterminer la loi de phase linéaire en fonction de la fréquence de la cellule de l'invention.

La figure 5 représente la variation d'une variable proportionnelle au retard de la cellule en fonction d'une variable proportionnelle à la fréquence. Ces variations sont données pour plusieurs valeurs d'une variable u proportionnelle au quotient de l'inductance mutuelle M par la somme de l'inductance L et de l'inductance mutuelle M.

Sur l'axe des ordonnées, on a représenté le rapport

$$\frac{d\theta}{dxk}$$

qui est proportionnel à $\frac{d\theta}{d\omega}$ où $\omega$ est la pulsation des signaux transmis, et par conséquent qui est proportionnel au retard D.

Sur l'axe des abscisses, on a représenté le terme xk qui est proportionnel à la fréquence.

On remarque que pour u compris entre -0,6 et -0,65, la variation

$$\frac{d\theta}{dxk}$$

est constante jusqu'à une valeur de xk égale à 1.

La variation du déphasage est donc constante jusqu'à xk = 1, c'est-à-dire jusqu'à une pulsation de coupure, $\omega_c$ ayant pour expression :

$$\omega_c = \frac{2}{2\sqrt{(L + M) \cdot C_2}}$$

Sur la figure 6, on a représenté les variations du retard D en fonction de la fréquence. Ces variations sont données pour plusieurs valeurs de $L_1$ et pour u = -0,65.

Sur l'axe des ordonnées, on a représenté le retard D en picosecondes et sur l'axe des abscisses, on a représenté la fréquence en gigahertz.

On remarque que, pour une inductance équivalente série $L_1$ comprise entre 0,25 et 0,5 nanohenry, la variation du retard D en fonction de la fréquence est une constante sur la gamme de fréquence de 2 à 20 gigaHertz.

A partir des résultats des courbes représentées en figures 5 et 6, on établit une loi de phase linéaire en fonction de la fréquence (u = -0,65, $L_1 = 2(L + M) = 0{,}35$ nanohenry, fréquence 2 à 22 gigahertz). Cette loi de phase linéaire en fonction de la fréquence permet d'obtenir à partir d'une cellule 4 décrite en référence à la figure 2 un filtre passe-tout à large bande en fréquence.

La figure 7 représente le dessin de la structure de la cellule 4 décrite en référence à la figure 2.

On voit une entrée 10 et une sortie 12 situées à distance l'une de l'autre. Entre l'entrée 10 et la sortie 12, une spirale 14 s'étend de façon particulièrement avantageuse sur environ un tour trois quarts. L'enroulement extérieur 16 de la spirale 14 s'étendant de l'entrée 10 jusqu'au point médian 22 de celle-ci constitue le premier élément inductif L formant une branche du T de la cellule 4 en T ponté.

L'enroulement intérieur 18 de la spirale 14

s'étendant du point médian 22 jusqu'à la sortie 12 constitue le second élément inductif L formant l'autre branche en T de la cellule 4 en T ponté.

Les deux enroulements 16 et 18 créent une mutuelle induction M.

Avantageusement, de façon à obtenir une loi de phase linéaire, les dimensions des deux enroulements 16 et 18 sont telles que le rapport u qui est égal à deux fois le quotient négatif de l'inductance mutuelle M par la somme de l'inductance L et de l'inductance mutuelle M soit égal à -0,65. En d'autres termes, les dimensions des deux enroulements 16 et 18 sont telles que le quotient de l'inductance mutuelle M par la somme de l'inductance L et de l'inductance mutuelle M soit égal à environ +0,325.

La spirale 14 est mise en parallèle sur une capacité 20 de structure métal-isolant-métal que l'on décrira ci-après. La capacité 20 constitue la capacité équivalente série $C_1$ du dispositif selon l'invention.

Le point médian 22 de la spirale 14 est relié par une autre capacité 24 de structure métal-isolant-métal, que l'on décrira ci-après, à un plan de masse 26.

La capacité 24 constitue la capacité équivalente parallèle $C_2$ du dispositif selon l'invention.

Avantageusement, la largeur entrée 10-sortie 12 est de l'ordre de 180 micromètres et la longueur spirale-plan de masse est de l'ordre de 360 micromètres. La structure de cette cellule occupe donc une surface d'AsGa de l'ordre de 0,06 millimètre carré pour une longueur équivalente dans l'air de l'ordre de 0,6 millimètres.

L'inductance équivalente série $L_1$ qui est égale à $2(L+M)$ a une valeur de l'ordre de 0,35 nanohenry.

La figure 8 représente une vue en coupe transversale de l'enroulement 16 de la spirale 14.

La structure de l'enroulement 16 est constituée par exemple d'une première couche 101 d'AsGa d'une épaisseur de l'ordre de 100 micromètres. Sur la première couche 101 est déposée par exemple une seconde couche 102 de nitrure de silicium ($Si_3N_4$) d'une épaisseur de l'ordre de 0,65 micromètres. Une couche 104 d'un métal dit "supérieur" recouvre par exemple la couche 102.

La couche du métal 104 a une épaisseur de l'ordre de 1 à 2,5 micromètres.

Sur la figure 9, on a représenté la structure de la capacité équivalente série $C_1$.

La structure métal-isolant-métal de la capacité 20 est la suivante : sur la première couche 101 d'AsGa est déposée une première couche 106 de métal dit "inférieur". Le matériau constituant la couche 106 est par exemple de l'or et son épaisseur est de l'ordre de 1 micromètre. Une couche 102 de diélectrique tel que du $Si_3N_4$ recouvre l'ensemble constitué des couches 101 et 106. Un évidement est réalisé dans la couche 102 pour réaliser un transfert T appelé "Topvia" par l'homme de l'art. Enfin, une couche 104 de métal dit "supérieur" recouvre l'ensemble constitué des couches 101, 106, 102 et remplit également l'évidement T. Le transfert T permet de relier le métal dit "supérieur" au métal dit "inférieur".

La couche 104 n'est pas uniforme, elle est interrompue pour définir une zone C où la couche 102 n'est pas recouverte par la couche 104.

La première armature de la capacité 20 est définie par la couche 104 tandis que la seconde armature de la capacité 20 est définie par la couche 106. La partie diélectrique de la capacité $C_1$ est définie par la couche 102.

La capacité $C_1$ est proportionnelle à la constante diélectrique de la couche 102, à la surface prise en sandwich entre les deux couches métalliques 104 et 106 et inversement proportionnelle à l'épaisseur de la couche $Si_3N_4$.

Le dépôt des couches 106, 102 et 104 est obtenu par des techniques bien connues de l'homme de l'art, par exemple la technique de dépôt chimique en phase vapeur. La forme de la couche 104 est obtenue par des techniques bien connues de l'homme de l'art, par exemple la technique photolithographique utilisant des masques et des gravures.

La couche 106 représentant le métal dit "inférieur" est représenté en hachuré sur la figure 7.

Sur la figure 10, on a représenté la structure de la cellule au niveau du plan de masse 26 de celle-ci. La capacité 24 réalisée entre le point milieu 22 et le plan de masse 26 est représentée par l'ensemble G et H. Cette capacité $C_2$ a la même structure que la capacité $C_1$, c'est-à-dire structure métal-isolant-métal. La première armature de la capacité $C_2$ est définie par la couche 104 tandis que la seconde armature de la capacité $C_2$ est définie par la couche 106. La couche 102 définit la partie diélectrique de la capacité 24.

Le plan de masse 26, représenté par l'ensemble D et E, est dans le prolongement de la capacité 24. Le plan de masse 26 comprend sur une couche 101 d'AsGa une couche 106 de métal dit "inférieur". La couche 106 s'étale sur l'ensemble de la longueur du plan de masse 26. Un trou 28 est réalisé dans la couche 101 une fois que toutes les couches supérieures ont été déposées. Enfin, une couche 108 de métal est déposée sous la couche 101 et remplit le trou 28 pour que la masse qui est sur le plan inférieur du circuit revienne sur le plan supérieur de celui-ci.

Sur la figure 11, on a représenté les pertes de la cellule en fonction de la fréquence.

Sur l'axe des ordonnées sont représentées les

pertes en décibels et sur l'axe des abscisses est représentée la fréquence en gigahertz. Les pertes sont dues à la mauvaise adaptation des impédances image et à la résistance du matériau constituant les inductances. Ce résultat est très utile pour la loi de phase linéaire de la cellule. Cette simulation a été réalisée sur une cellule dont les capacités ont pour valeur : $C_2$ = 440 femtofarads et $C_1$ = 40 femtofarads, et dont l'écart entre le premier enroulement 16 et le second enroulement 18 est de 15 micromètres.

On remarque que l'on a moins de 1 décibel de pertes en transmission jusqu'à 22 gigahertz, c'est-à-dire qu'on réalise bien la fonction filtre passe-tout.

Sur la figure 12, on a représenté la variation du déphasage de la cellule en fonction de la fréquence.

Sur l'axe des ordonnées, on a représenté le déphasage en degrés et sur l'axe des abscisses on a représenté la fréquence en gigahertz. Sur la gamme de fréquence de 2 à 22 gigahertz, la longueur équivalente dans l'air varie de 6,3 millimètres à 6,5 millimètres. Cette courbe indique que la loi dé phase est bien linéaire.Grâce à l'invention, une surface d'AsGa de 0,1 millimètre carré permet d'obtenir une ligne de transmission équivalente dans l'air d'une longueur de l'ordre de 1 centimètre, ce qui permet de gagner énormément de place, à savoir un rapport de l'ordre de 10 par rapport à la réalisation de lignes de transmission classiques.

Sur la figure 13, on a représenté la cascade de plusieurs cellules 4 décrites en référence à la figure 7. Cette cascade est possible grâce à l'adaptation impédance image. Sur la figure 13 sont représentées neuf cellules 4 montées en série. Ces cellules 4 sont distribuées autour d'un même plan de masse 26. Cette disposition de neuf cellules 4 occupe une surface globale égale à 800x600 micromètres. Une telle disposition de neuf cellules 4 permet d'obtenir une ligne de transmission d'une longueur équivalente dans l'air de 5 centimètres. Le dessin d'une telle disposition de neuf cellules est obtenu par des outils de CAO.

Sur la figure 14, la référence 30 désigne une pluralité de cellules 4 montées en série comme décrit en référence à la figure 13 et qui définissent un bout d'une ligne à retard dont la longueur est proportionnelle au nombre de cellules 4. La commutation de cette pluralité de cellules 4 est effectuée à l'aide de transistors à effet de champ. La pluralité 30 est reliée d'une part à l'entrée de la ligne à retard par l'intermédiaire des transistors 32 et 34 et d'autre part à la sortie de la ligne à retard par l'intermédiaire des transistors 36 et 38. Les transistors 32 et 38 sont montés en série, c'est-à-dire que la source du transistor est reliée au drain de celui-ci via la grille qui reçoit une tension V pilotant la commutation du transistor. Par exemple, lorsque la tension V appliquée à la grille du transistor est égale à -9 Volts, le transistor est équivalent à sa capacité $C_{off}$, ce qui place le transistor dans son état bloqué tandis que lorsque la tension V appliquée à la grille du transistor est égale à 0 Volt, le transistor est équivalent à sa résistance $R_{on}$, ce qui place le transistor dans son état passant.

Les transistors 34 et 36 sont montés en parallèle, c'est-à-dire que la source ou le drain du transistor est relié à la masse; la grille reçoit une tension V qui pilote la commutation du transistor. Par exemple, lorsque la tension V appliquée à la grille du transistor est égale à -9 Volts, le transistor est équivalent à sa capacité $C_{off}$, ce qui place le transistor dans son état bloqué tandis que lorsque la tension est égale à 0 Volt, le transistor est équivalent à sa résistance $R_{on}$, ce qui place le transistor dans son état passant.

Quand les transistors 32 et 38 sont passants et les transistors 36, 34 et 40 bloqués, le signal de transmission circule de l'entrée de la ligne à retard par la pluralité 30 de cellules 4 vers la sortie de la ligne à retard. Inversement, lorsque les transistors 36, 34 et 40 sont passants et les transistors 32 et 38 bloqués, le signal de transmission circule de l'entrée par le transistor passant 40 vers la sortie de la ligne à retard (sans passer par la pluralité 30).

## Revendications

**1.** Dispositif de retard hyperfréquence, comportant au moins un quadripôle du type dit "cellule dérivée en m", agencé en filtre passe-tout, avec une loi de phase linéaire en fonction de la fréquence, le quadripôle étant constitué d'une cellule en T ponté comprenant :

- deux inducteurs de même valeur (L) montés en série pour former les deux branches du T, et possédant une inductance mutuelle (M) ;
- une capacité ($C_2$) définissant l'âme du T ; et
- une autre capacité ($C_1$) formant le pont ;

caractérisé en ce que le dessin de la structure dudit dispositif en technologie planaire comprend au moins une cellule élémentaire (4), constituée entre une entrée (10) et une sortie (12) situées à distance l'une de l'autre, d'une spirale (14), mise en parallèle sur une capacité (20) de structure métal-isolant-métal, tandis que le point médian (22) de la spirale (14) est relié par l'intermédiaire d'une autre capacité (24) de structure métal-isolant-métal à un plan de masse (26).

**2.** Dispositif selon la revendication 1, caractérisé en ce que le quadripôle possède la même impédance image en entrée et en sortie, cette impédance étant sensiblement égale à 50 ohms.

**3.** Dispositif selon l'une des revendications 1 et 2, caractérisé en ce que le quadripôle obéit sensiblement à la relation :

$$C_2 \cdot \left(\frac{L - M}{L + M}\right) = 4 \cdot C_1$$

**4.** Dispositif selon l'une des revendications 1 à 3, caractérisé en ce que le quotient de l'inductance mutuelle (M) par la somme de l'inductance (L) et de l'inductance mutuelle (M) est compris entre +0,2 et +0,4, de préférence entre +0,28 et +0,34, environ.

**5.** Dispositif selon la revendication 4, caractérisé en ce que ledit quotient est compris entre +0,30 et +0,33.

**6.** Dispositif selon l'une des revendications précédentes, caractérisé en ce que ledit quadripôle est monté commutable en parallèle sur une voie directe formant sensiblement un court-circuit.

**7.** Dispositif selon l'une des revendications précédentes, caractérisé en ce qu'il est réalisé en technologie monolithique sur arséniure de gallium.

**8.** Dispositif selon l'une des revendications précédentes, caractérisé en ce que la spirale (14) s'étend sur environ un tour trois quarts.

**9.** Dispositif selon l'une des revendications précédentes, caractérisé en ce qu'il comprend plusieurs cellules (4) distribuées autour d'un même plan de masse (26), et montées en série.

**10.** Dispositif selon l'une quelconque des revendications précédentes, caractérisé en ce qu'il s'applique à la réalisation de lignes de transmission en hyperfréquence à longueur programmable sur plusieurs bits.

**Claims**

**1.** Ultra-high frequency delay device, comprising at least one quadripole of the type known as "shunted m-section", constructed as all-pass filter, with a linear phase law as a function of the frequency, the quadripole being composed of a bridged T-section comprising:

- two inductors of equal value (L) connected in series to form the two arms of the T, and possessing a mutual inductance (M);
- a capacitor ($C_2$) defining the vertical stroke of the T; and
- another capacitor ($C_1$) forming the bridge;

characterized in that the design of the structure of said device in planar technology comprises at least one elementary section (4), formed between an input (10) and an output (12) situated at a distance apart from one another, of a spiral (14) connected in parallel with a capacitor (20) of metal-insulator-metal construction, while the median point (22) of the spiral (14) is connected via another capacitor (24) of metal-insulator-metal construction to an earth plane (26).

**2.** Device according to Claim 1, characterized in that the quadripole possesses the same image impedance at the input and at the output, this impedance being substantially equal to 50 ohms.

**3.** Device according to one of Claims 1 and 2, characterized in that the quadripole substantially obeys the relationship:

$$C_2 \cdot \left(\frac{L - M}{L + M}\right) = 4 \cdot C_1 \quad .$$

**4.** Device according to one of Claims 1 to 3, characterized in that the quotient of the mutual inductance (M) divided by the sum of the inductance (L) and the mutual inductance (M) is from +0.2 to +0.4 and preferably from +0.28 to +0.34 approximately.

**5.** Device according to Claim 4, characterized in that said quotient is from +0.30 to +0.33.

**6.** Device according to one of the preceding Claims, characterized in that said quadripole is connected so that it can be switched in parallel to a direct path forming substantially a short-circuit.

**7.** Device according to one of the preceding Claims, characterized in that it is constructed

in monolithic technology on gallium arsenide.

**8.** Device according to one of the preceding Claims, characterized in that the spiral (14) extends around approximately one and three quarter turns.

**9.** Device according to one of the preceding Claims, characterized in that it comprises a plurality of sections (4), distributed around a single earth plane (26) and connected in series.

**10.** Device according to any one of the preceding Claims, characterized in that it is applicable to the construction of ultra-high frequency transmission lines having a length programmable over several bits.

**Patentansprüche**

**1.** Ultrahochfrequenz-Verzögerungseinrichtung mit mindestens einer Vierpolschaltung in der Art eines als Breitbandfilter betriebenen sogenannten "m-Verzweigungsglieds" mit frequenzabhängigem linearem Phasenverlauf, wobei die Vierpolschaltung aus einem überbrückten T-Glied besteht und folgendes aufweist:
- zwei in Reihe liegende Induktionselemente mit gleichem Wert (L) zur Bildung der beiden T-Zweige, welche einen Wechselinduktionskoeffizienten (M) aufweisen,
- ein C-Glied ($C_2$), welches den Hauptstrang des T-Glieds bildet; und
- ein weiteres C-Glied ($C_1$), welches die Brücke bildet;

dadurch gekennzeichnet, daß die konstruktive Auslegung der in Planartechnik ausgeführten Vorrichtung mindestens ein Elementarglied (4) aufweist, welches zwischen einem Eingang (10) und einem in Abstand von diesem liegenden Ausgang (12) einer parallel zu einem C-Glied (20) geschalteten Spirale ausgebildet ist, wobei das C-Glied (20) aus einer Schichtung Metall/ Nichtleiter/Metall aufgebaut ist, während der in der Mitte der Spirale (14) liegende Punkt mittels eines weiteren C-Glieds (24), das aus einer Schichtung Metall/Nichtleiter/ Metall besteht, mit einer Masse-Ebene (26) verbunden ist.

**2.** Vorrichtung nach Anspruch 1, dadurch gekennzeichnet, daß die Vierpolschaltung eingangs- und ausgangsseitig die gleiche Spiegelimpedanz aufweist, welche im wesentlichen gleich 50 Ohm ist.

**3.** Vorrichtung nach Anspruch 1, dadurch gekennzeichnet, daß die Vierpolschaltung im wesentlichen der folgenden Beziehung genügt:

$$C_2 \cdot \left(\frac{L - M}{L + M}\right) = 4 \cdot C_1 .$$

**4.** Vorrichtung nach einem der Ansprüche 1 bis 3, dadurch gekennzeichnet, daß der Quotient aus dem Wechselinduktionskoeffizienten (M) und der Summe aus der Induktivität (L) und dem Wechselinduktionskoeffizienten (M) zwischen etwa + 0,2 und + 0,4, vorzugsweise + 0,28 und + 0,34, liegt.

**5.** Vorrichtung nach Anspruch 4, dadurch gekennzeichnet, daß der Quotient einen Wert zwischen + 0,30 und + 0,33 besitzt.

**6.** Vorrichtung nach einem der vorhergehenden Ansprüche, dadurch gekennzeichnet, daß die Vierpolschaltung so angeordnet ist, daß sie parallel zu einem durchgehenden Kanal umschaltbar ist, welcher im wesentlichen einen Kurzschluß bildet.

**7.** Vorrichtung nach einem der vorhergehenden Ansprüche, dadurch gekennzeichnet, daß sie in Monolithtechnik auf Galliumarsenid ausgeführt ist.

**8.** Vorrichtung nach einem der vorhergehenden Ansprüche, dadurch gekennzeichnet, daß die Spirale (14) sich über etwa eindreiviertel Windungsgänge erstreckt.

**9.** Vorrichtung nach einem der vorhergehenden Ansprüche, dadurch gekennzeichnet, daß sie mehrere Elementarglieder (4) aufweist, die um dieselbe Masse-Ebene (26) verteilt und in Reihe geschaltet sind.

**10.** Vorrichtung nach einem der vorhergehenden Ansprüche, dadurch gekennzeichnet, daß sie zur Realisierung von Ultrahochfrequenz-Übertragungsleitungen mit programmierbarer Länge über mehrere Bit eingesetzt ist.

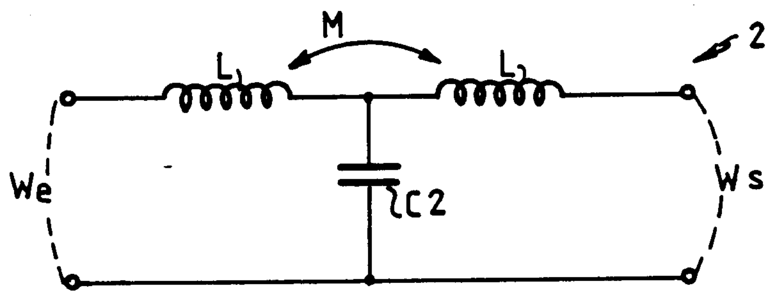


FIG.1

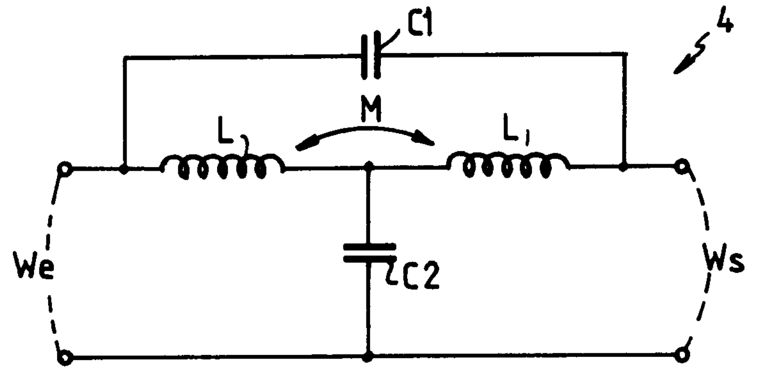


FIG. 2

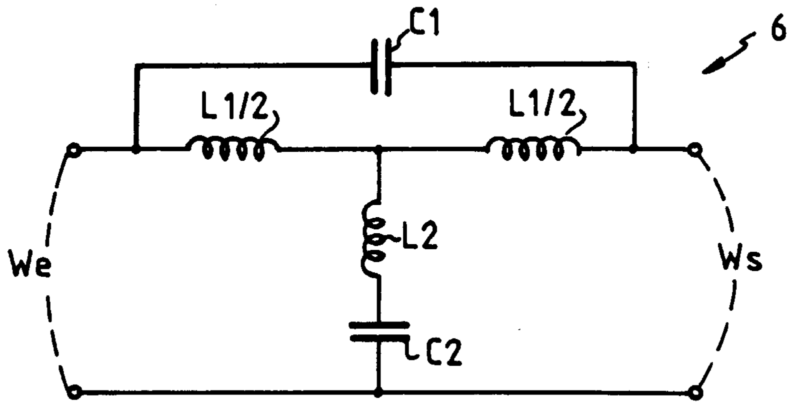


FIG. 3

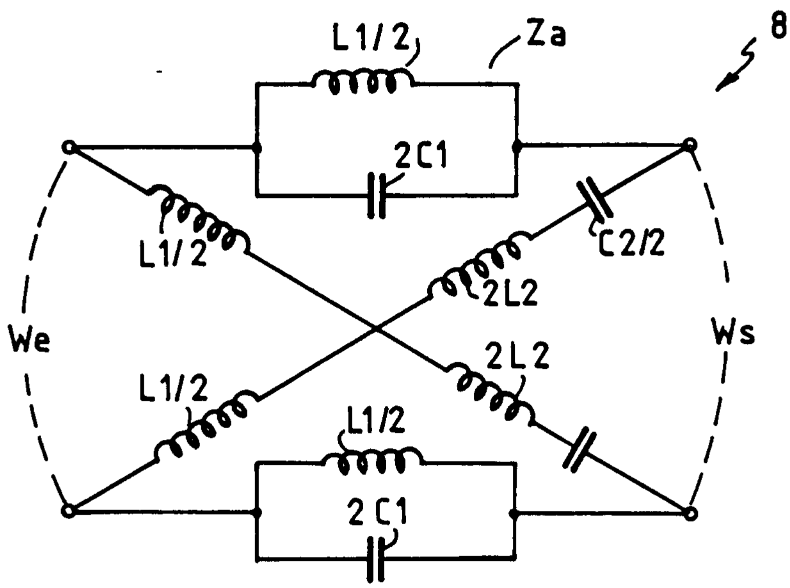


FIG. 4

FIG.5

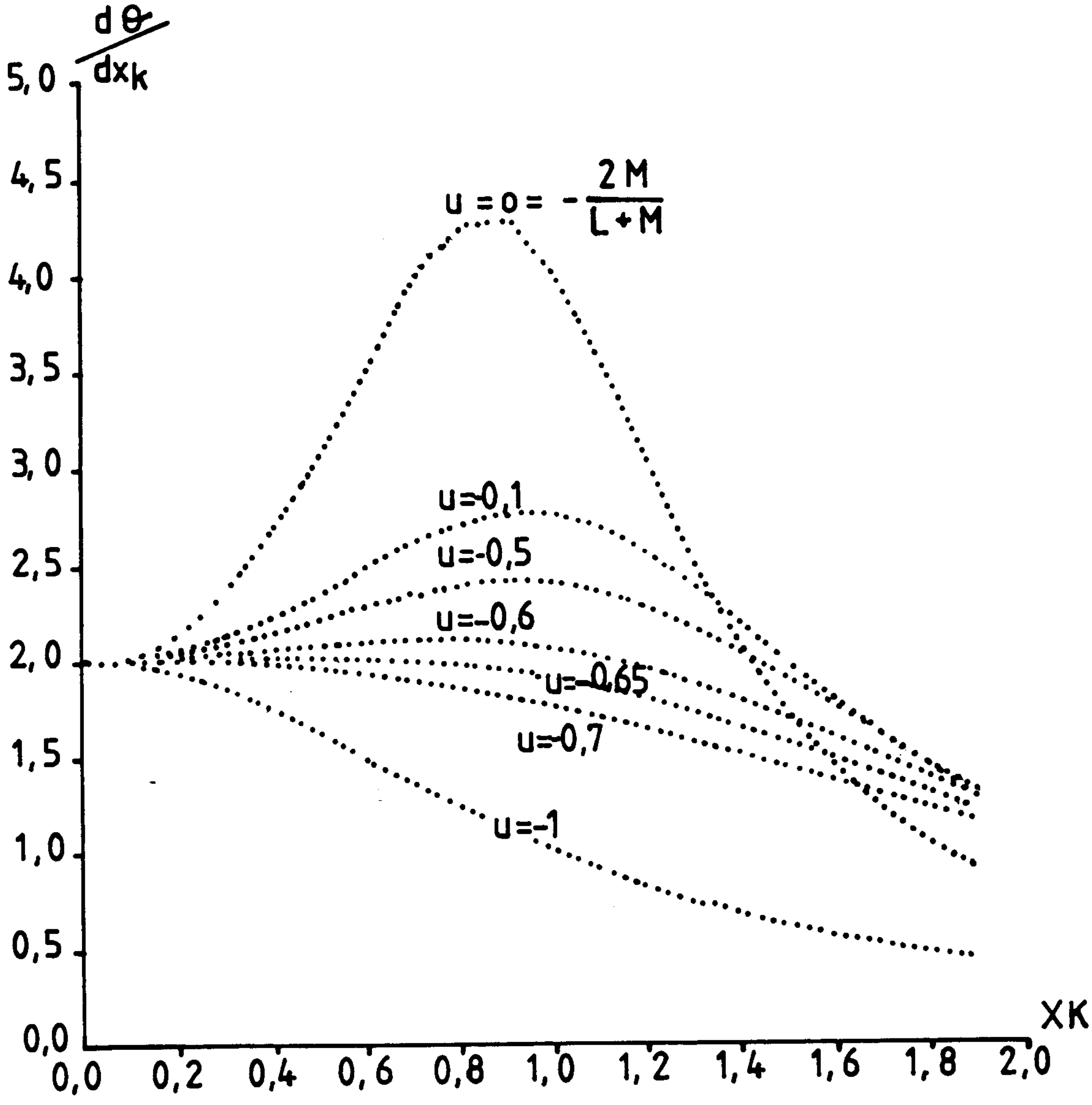
dθ/dxk
5,0
4,5
4,0
3,5
3,0
2,5
2,0
1,5
1,0
0,5
0,0
u = o = - 2M/L+M
u=-0,1
u=-0,5
u=-0,6
u=-0,65
u=-0,7
u=-1
XK
0,0
0,2
0,4
0,6
0,8
1,0
1,2
1,4
1,6
1,8
2,0

FIG. 6

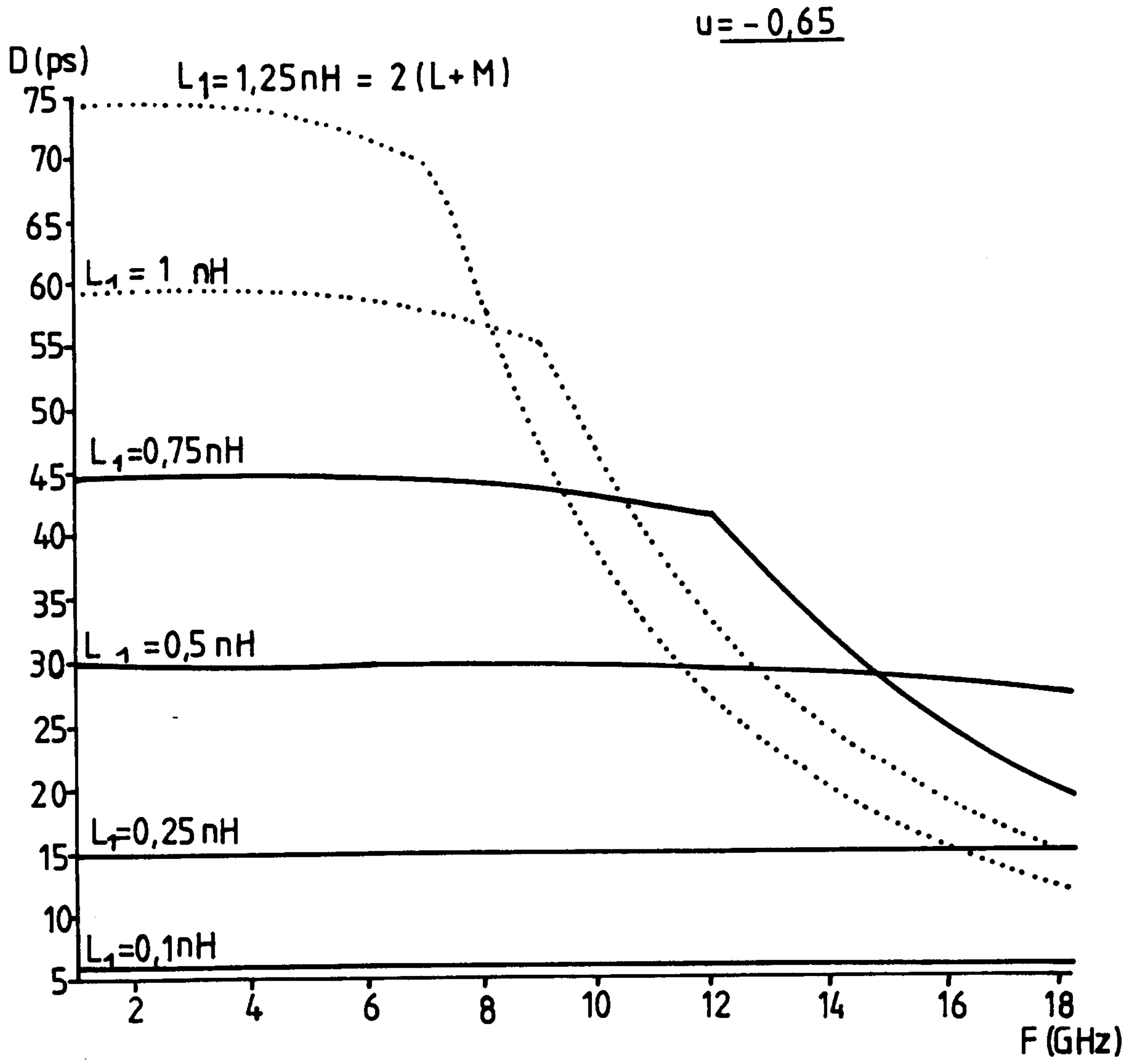
u = - 0,65
D (ps)
L1 = 1,25 nH = 2 (L+M)
L1 = 1 nH
L1 = 0,75 nH
L1 = 0,5 nH
L1 = 0,25 nH
L1 = 0,1 nH
75
70
65
60
55
50
45
40
35
30
25
20
15
10
5
2
4
6
8
10
12
14
16
18
F (GHz)

FIG.7

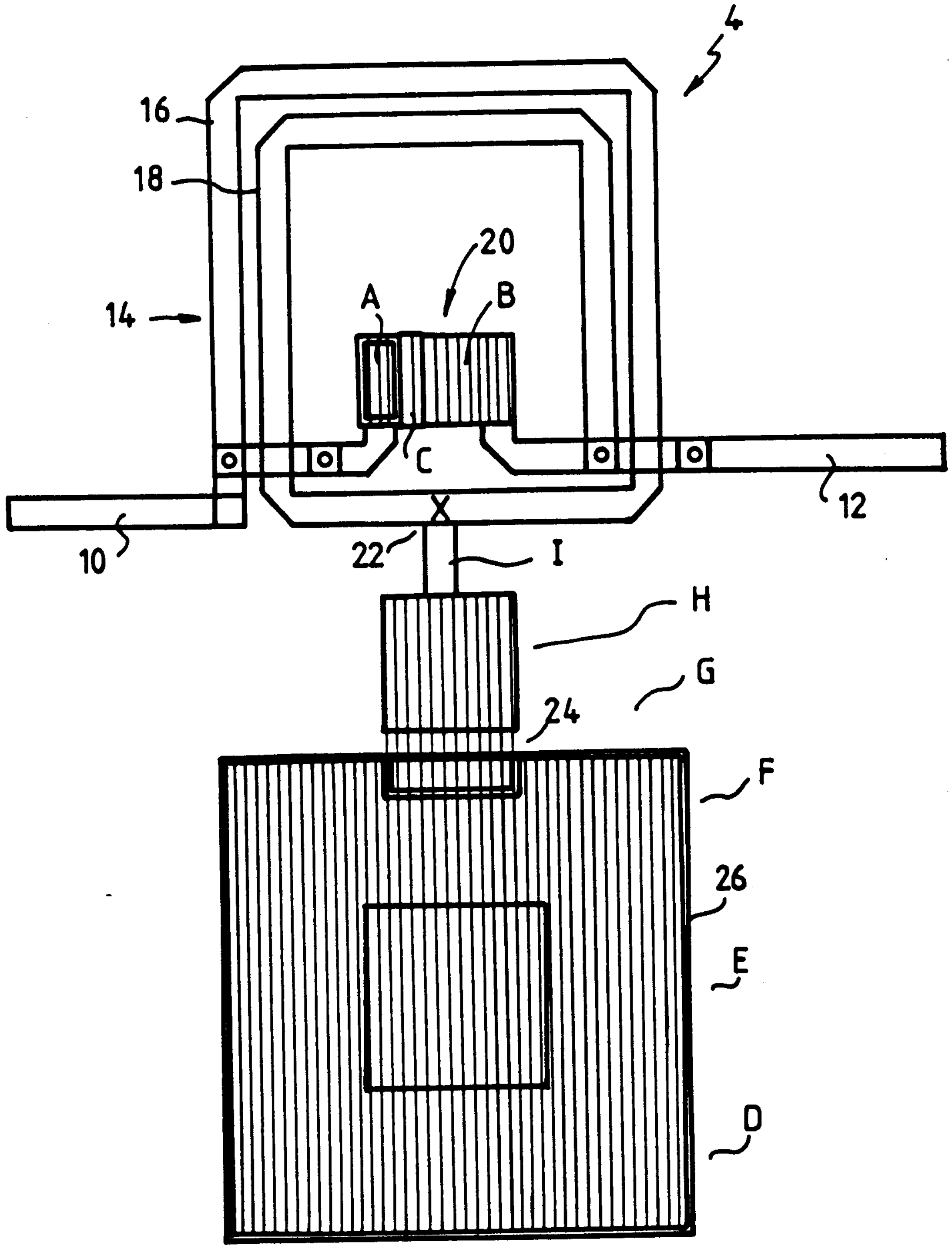

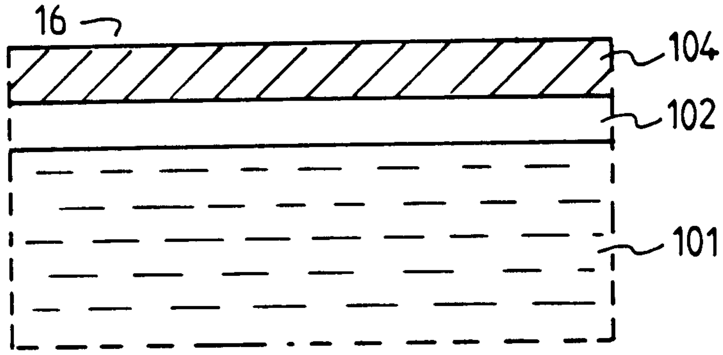


FIG.8

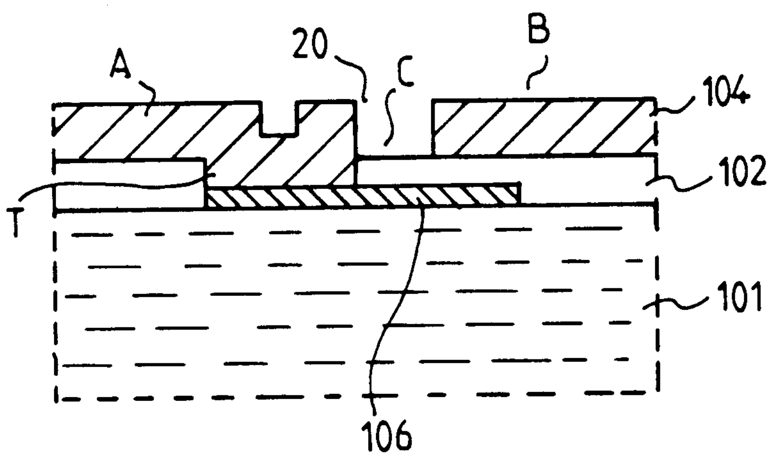


FIG. 9

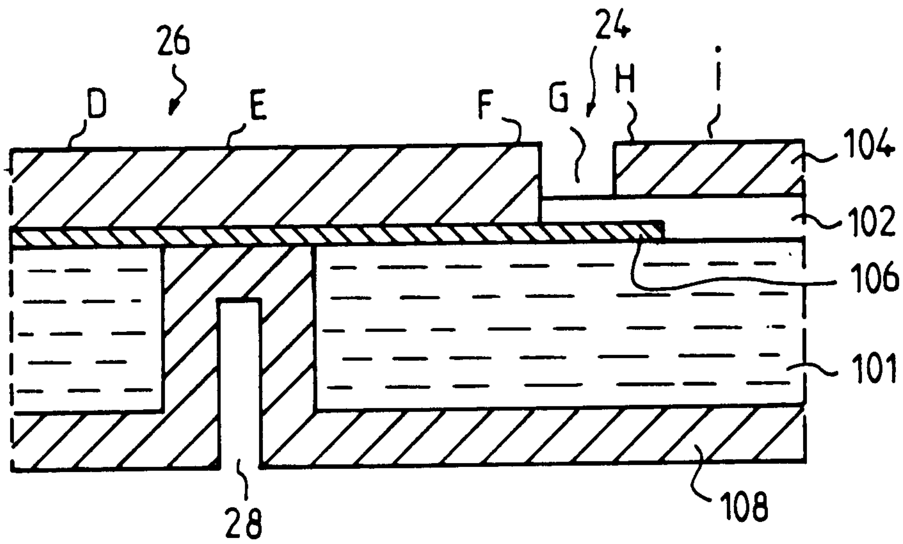


FIG.10

FIG. 11

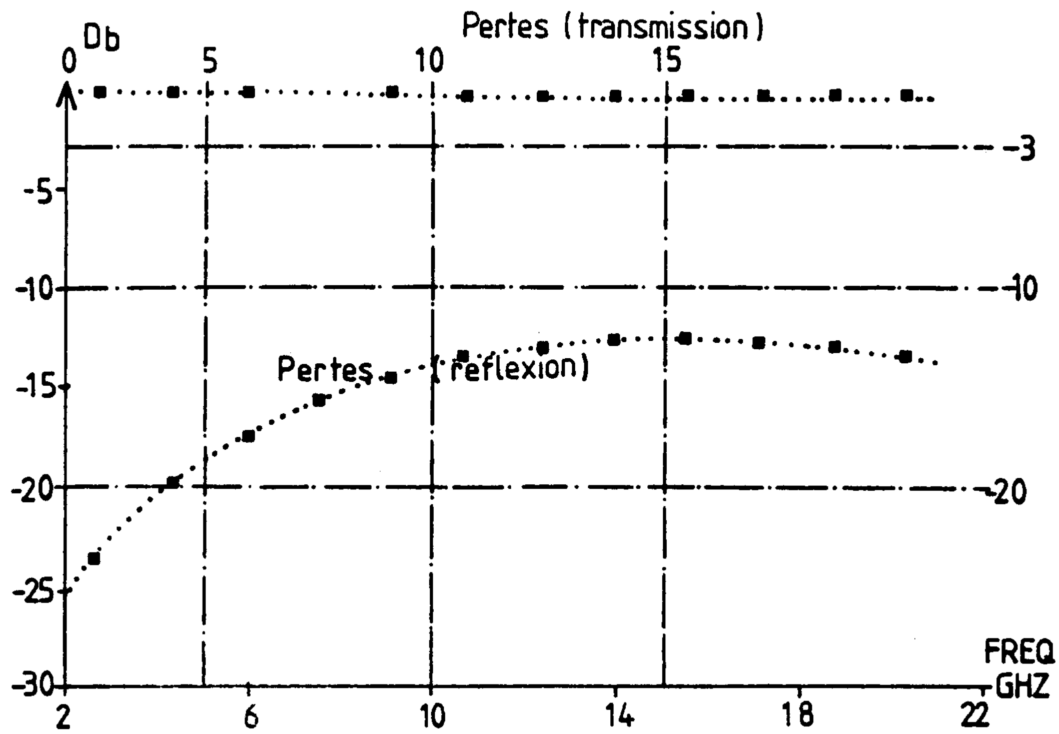
Pertes (transmission)
Db
0
5
10
15
-3
-5
-10
-10
Pertes (reflexion)
-15
-20
-20
-25
-30
FREQ
GHZ
2
6
10
14
18
22

FIG. 12

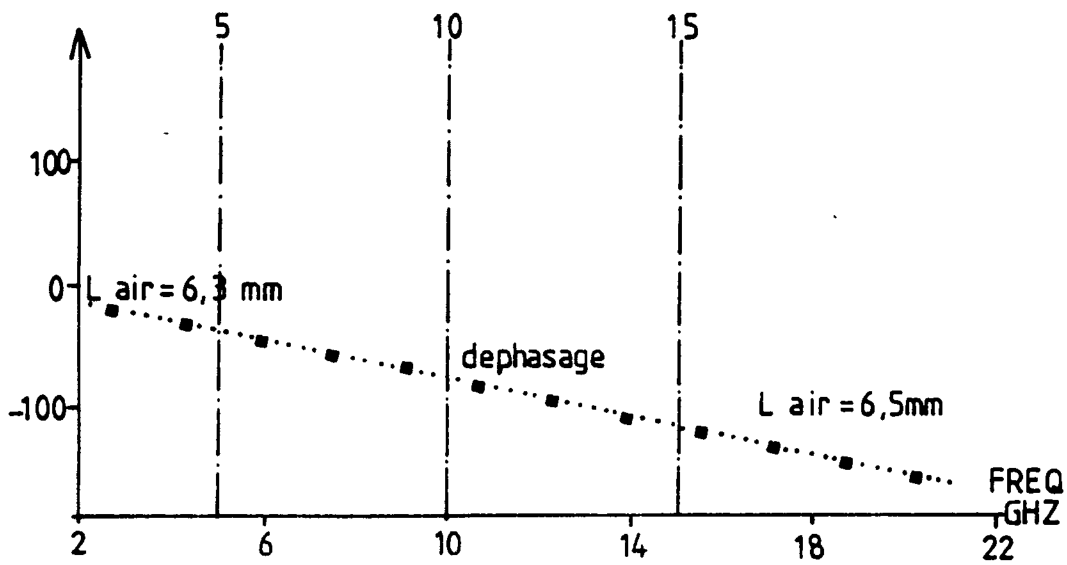
5
10
15
100
0
L air = 6,3 mm
dephasage
-100
L air = 6,5mm
FREQ
GHZ
2
6
10
14
18
22

FIG.13

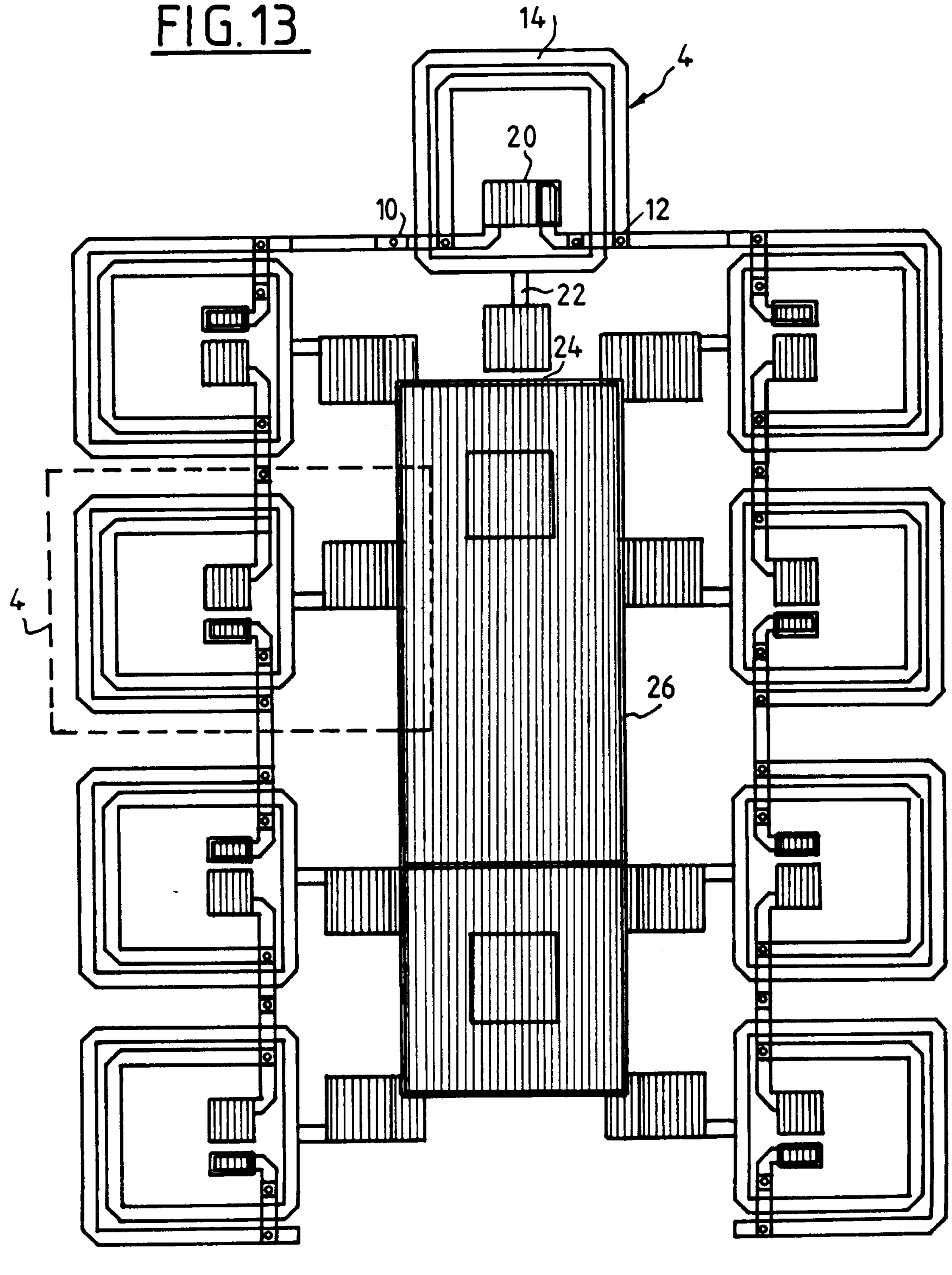

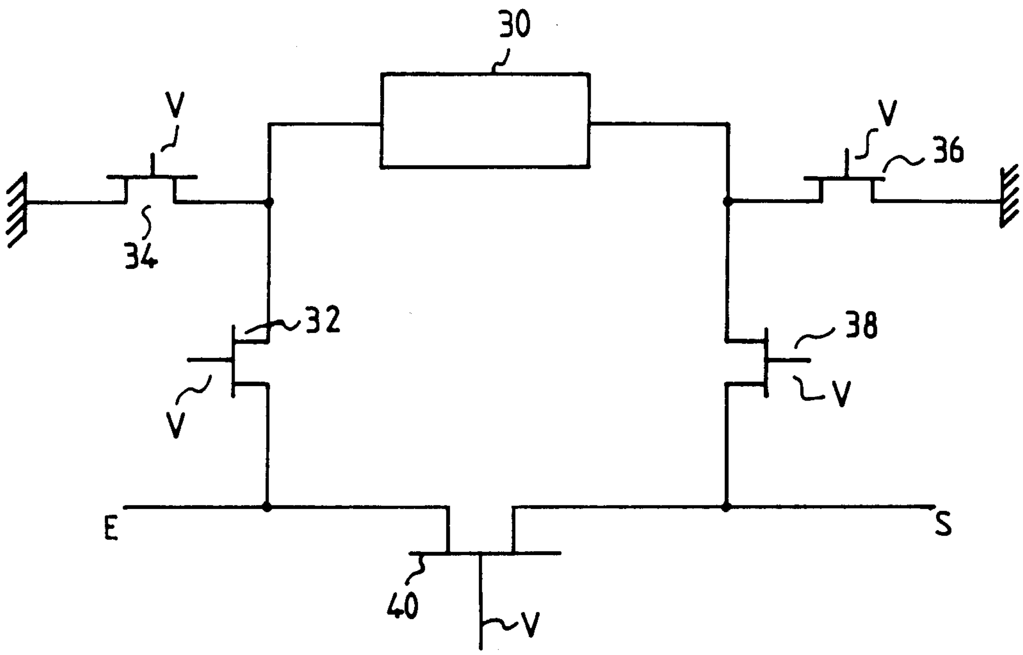


FIG. 14